# EUROPEAN PATENT APPLICATION

(11) **EP 2 682 838 A1**
(43) Date of publication of application: **08.01.2014**
(21) Application number: 12755709.8
(22) Date of filing: 29.02.2012
(51) Int. Cl.: G05F 1/67, H01L 31/04, H01L 31/042

(54) **CONTROL DEVICE OF SOLAR POWER CONVERSION UNIT, METHOD OF CONTROLLING THEREOF, AND SOLAR POWER GENERATION APPARATUS**

(30) Priority: 04.03.2011 JP 2011047703
(71) Applicant: Daikin Industries, Ltd., Osaka-shi, Osaka 530-8323 (JP)
(72) Inventor: MATSUURA, Tetsuya, Sakai-shi Osaka 591-8511 (JP); YASUI, Yoshitaka, Sakai-shi Osaka 591-8511 (JP)
(74) Representative: Goddar, Heinz J.
(86) International application number: PCT/JP2012/001378
(87) International publication number: WO 2012/120836

(57) **Abstract**

A system for controlling a solar power conversion unit includes a power detecting section (41, 42) configured to detect output power of at least one solar cell (20), an insolation amount inputting section (46) to which an index related to an amount of insolation is input, a power correcting section (47) configured to correct the output power detected by the power detecting section (41, 42) on the basis of the index related to the amount of insolation input to the insolation amount inputting section (46), and a voltage controlling section (45) configured to change an output voltage of the solar cell (20) on the basis of the output power corrected by the power correcting section (47) such that the output power of the solar cell (20) approaches the maximum power point.

## Description

### TECHNICAL FIELD

The present disclosure relates to a control system for a solar power conversion unit, a control method for the solar power conversion unit, and a solar power generation system. The present disclosure particularly relates to a means for increasing output power of a solar cell.

### BACKGROUND ART

Solar power generation systems which generate power by using solar energy have been conventionally known. Some of the solar power generation systems perform maximum power point tracking (MPPT) control by which output power (the operating point) of a solar cell is caused to approach the maximum power point.

Patent Document 1 discloses a solar power generation system which performs the MPPT control. In the MPPT control, the output voltage of a solar cell is slightly changed at different operating points, and then, changes in the output power of the solar cell caused by these changes in the output voltage are detected. If an increase in the output power is detected, the output voltage is further slightly changed in the same direction as the direction in which the output voltage was previously changed (i.e. in the increasing direction or the decreasing direction). If a decrease in the output power is detected, the output voltage is slightly changed in the direction opposite to the direction in which the output voltage was previously changed. Thus, in the MPPT control, the output voltage of the solar cell is controlled in a stepwise manner such that the output power of the solar cell approaches the maximum power point. In this manner, an attempt to improve the power generation efficiency of the solar power generation system is made.

### CITATION LIST

### PATENT DOCUMENT

PATENT DOCUMENT 1: Japanese Patent Publication No. H08-179840

### SUMMARY OF THE INVENTION

### TECHNICAL PROBLEM

In control such as the above-described MPPT control, by which an output voltage of a solar cell is adjusted while detecting output power of the solar cell, an error between the detected output power and actual output power is sometimes caused. Specifically, if sunlight suddenly hits a solar cell which has been in the shade, for example, the amount of insolation with which the solar cell is irradiated abruptly increases. This abrupt increase in the amount of insolation causes the output power of the solar cell to increase abruptly. When the MPPT control is performed under these circumstances, it is impossible to distinguish an increase in the output power caused by a change in the output voltage from an increase in the output power caused by an abrupt increase in the amount of insolation. Accordingly, despite the fact that, for example, the output voltage of the solar cell should be increased in order to cause the output power of the solar cell to approach the maximum power point, control by which the output voltage is reduced is disadvantageously carried out, resulting in that the output power rather moves away from the maximum power point.

It is therefore an object of the present disclosure to reduce losses of a power production of a solar cell which are caused by abrupt changes in amount of insolation.

### SOLUTION TO THE PROBLEM

A first aspect of the present disclosure relates to a control system for a solar power conversion unit configured to convert direct-current power output by at least one solar cell (20) into alternating-current power. The control system for the solar power conversion unit includes: a power detecting section (41, 42) configured to detect the power output by the solar cell (20); an insolation amount inputting section (46) to which an index related to an amount of insolation is input; a power correcting section (47) configured to correct the output power detected by the power detecting section (41, 42) on the basis of the index related to the amount of insolation input to the insolation amount inputting section (46); and a voltage controlling section (45) configured to change an output voltage of the solar cell (20) on the basis of the output power corrected by the power correcting section (47) such that the output power of the solar cell (20) approaches a maximum power point.

According to the first aspect, the power detecting section (41, 42) detects the output power of the solar cell. The index related to the amount of insolation is input to the insolation amount inputting section (46). The power correcting section (47) corrects, on the basis of the index related to the amount of insolation, the output power which has been detected by the power detecting section (41, 42). The voltage controlling section (45) changes the output voltage of the solar cell (20) on the basis of the corrected output power such that the output power of the solar cell (20) approaches the maximum power point. In this manner, even if an abrupt change in the amount of insolation causes an error between the detected output power and actual output power, it is possible to cause the output power of the solar cell (20) to approach the maximum power point while taking the error into account.

A second aspect of the present disclosure relates to the control system of the first aspect, wherein the at least one solar cell (20) includes multiple solar cells (20), the system further includes a power production inputting section (61) to which power productions of the multiple solar cells (20) are input and an insolation amount estimation section (63) configured to estimate the amount of insolation on the basis of the multiple power productions input to the power production inputting section (61), and the amount of insolation estimated by the insolation amount estimation section (63) is input to the insolation amount inputting section (46).

According to the second aspect, the power productions of the multiple solar cells (20) located in a predetermined area are input to the power production inputting section (61). The insolation amount estimation section (63) estimates the amount of insolation of the area on the basis of these power productions. Specifically, since the power production of the solar cell (20) is substantially proportional to the amount of insolation, the amount of insolation of the area where the multiple solar cells (20) are located can be calculated by utilizing the power productions of the multiple solar cells (20). The calculated amount of insolation is input to the insolation amount inputting section (46) to be utilized for correcting the output power of the solar cell (20).

A third aspect of the present disclosure relates to the control system of the second aspect, wherein the power correcting section (47) corrects the output power detected by the power detecting section (41, 42) by means of multiplying the output power detected by the power detecting section (41, 42) by a rate of change of the amount of insolation.

According to the third aspect, the output power detected by the power detecting section (41, 42) is multiplied by the rate of change of the amount of insolation, thereby calculating the corrected output power allowing for an abrupt change in the amount of insolation.

A fourth aspect of the present disclosure relates to a control method for a solar power conversion unit configured to convert direct-current power output by at least one solar cell (20) into alternating-current power. This control method for the solar power conversion unit includes: correcting detected output power of the solar cell (20) on the basis of an index related to an amount of insolation; and changing an output voltage of the solar cell (20) on the basis of the corrected output power such that the output power of the solar cell (20) approaches a maximum power point.

According to the control method of the fourth aspect, the detected output power is corrected based on the index related to the amount of insolation. The output voltage of the solar cell (20) is changed based on the corrected output power such that the output power of the solar cell (20) approaches the maximum power point. In this manner, even if an abrupt change in the amount of insolation causes an error between the detected output power and actual output power, it is possible to cause the output power of the solar cell (20) to approach the maximum power point while taking the error into account.

A fifth aspect of the present disclosure relates to the control method of the fourth aspect, wherein the at least one solar cell (20) includes multiple solar cells (20), the amount of insolation is estimated based on power productions of the multiple solar cells (20), and detected output power of the solar cells (20) is corrected based on the estimated amount of insolation.

According to the fifth aspect, the amount of insolation of an area where the multiple solar cells (20) are located is estimated based on the power productions of the multiple solar cells (20). The amount of insolation estimated in this manner is utilized to correct the output power of the solar cells (20).

A sixth aspect of the preset disclosure relates to the control method of the fifth aspect, wherein the detected output power of the solar cells (20) is corrected by means of multiplying the detected output power of the solar cells (20) by a rate of change of the amount of insolation.

According to the sixth aspect, the detected output power is multiplied by the rate of change of the amount of insolation, thereby calculating the corrected output power allowing for an abrupt change in the amount of insolation.

A seventh aspect of the present disclosure relates to a solar power generation system. This solar power generation system includes multiple solar cells (20); multiple solar power conversion units (30) each configured to convert direct-current power output by an associated one of the solar cells (20) into alternating-current power; and the control system (40, 60) of the second or third aspect.

In the solar power generation system of the seventh aspect, the insolation amount estimation section (63) of the control system (40, 60) estimates the amount of insolation on the basis of the power productions of the multiple solar cells (20). Each of the power correcting sections (47) of the control system (40, 60) corrects the output power of the associated solar cell (20) on the basis of the estimated amount of insolation. Each of the voltage controlling sections (45) of the control system (40, 60) changes the output voltage of the associated solar cell (20) such that the output power of the associated solar cell (20) approaches the maximum power point.

### ADVANTAGES OF THE INVENTION

According to the first and fourth aspects of the present disclosure, even if an abrupt change in the amount of insolation has caused an error between detected output power and actual output power, it is possible to adjust the output voltage of the solar cell (20) while taking the error into account. Consequently, even under the conditions as described above, it is ensured that the output power of the solar cell (20) approaches the maximum power point, and the power generation efficiency of the solar cell (20) can be improved.

According to the second and fifth aspects of the present disclosure, it is possible to calculate the average amount of insolation of the area where multiple solar cells (20) are located on the basis of the power productions and without measuring the amount of insolation of the area. Accordingly, devices for measurement of amount of insolation are no longer necessary, and the costs can be reduced. In addition, information on the power production of each of the solar cells (20) can be utilized for other purposes.

According to the third and sixth aspects of the present disclosure, it is possible to correct the output power of the solar cells (20) by means of multiplying the detected output power by the rate of change of the amount of insolation such that the corrected output power allows for an abrupt change in the amount of insolation

According to the seventh aspect of the present disclosure, it is possible to provide a solar power generation system which can reduce losses of solar cells (20) which are caused by abrupt changes in the amount of insolation.

### BRIEF DESCRIPTION OF THE DRAWINGS

[FIG. 1] FIG. 1 is a block diagram schematically illustrating a configuration of a solar power generation system according to an embodiment.
[FIG. 2] FIG. 2 is a graph showing a relation between the amount of insolation and the power production of a solar cell.
[FIG. 3] FIG. 3 is flowchart of the MPPT control performed in the solar power generation system of the embodiment.
[FIG. 4] FIG. 4 is a graph showing an example of fluctuation of the operating point of a solar cell in the MPPT control of the solar power generation system of the embodiment.
[FIG. 5] FIG. 5 is a graph showing an example of fluctuation of the operating point of a solar cell in the MPPT control performed in a conventional solar power generation system.

### DESCRIPTION OF EMBODIMENTS

An embodiment of the present disclosure will be described below in detail with reference to the drawings.

### «Embodiment»

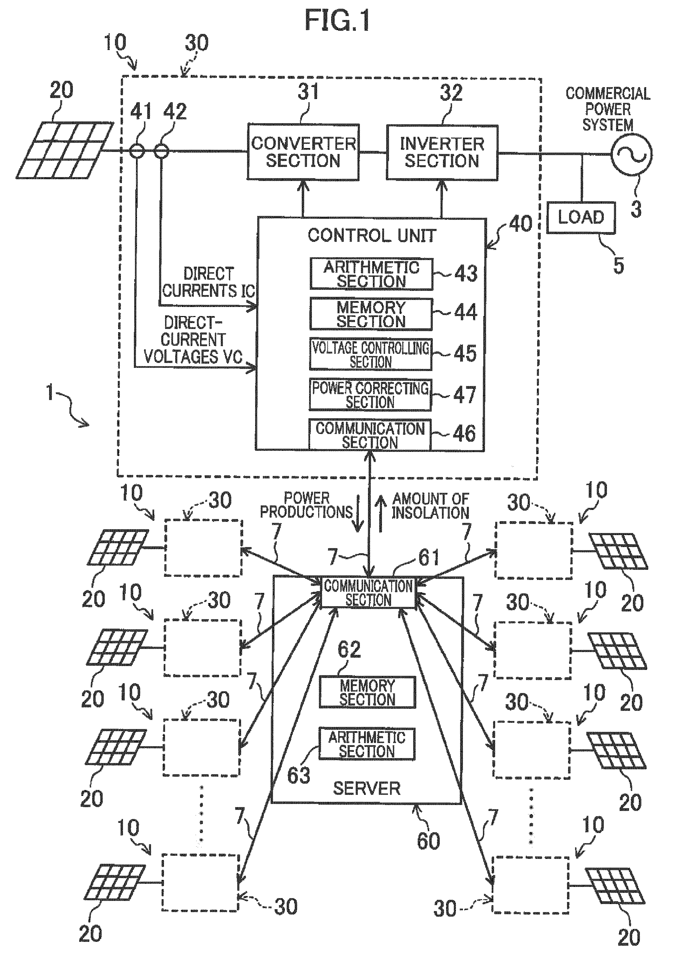

As illustrated in FIG. 1, a solar power generation system (1) according to this embodiment includes multiple solar power generation units (10) and a server (60) connected to the solar power generation units (10) through a network. The solar power generation units (10) are provided to houses located in a predetermined region (e.g., an area of 1-5 km²). Thus, in the solar power generation system (1), all of the solar power generation units (10) are under substantially uniform environmental conditions (conditions related to e.g., insolation and temperatures).

### <Configuration of Solar Power Generation Unit>

A configuration of the solar power generation unit (10) is now described with reference to FIG. 1. The solar power generation unit (10) is configured to convert direct-current power which has been generated from sunlight into alternating-current power, and to supply, in conjunction with a commercial power system (3), the alternating-current power to a load (5).

The solar power generation unit (10) includes a photovoltaic (PV) array (20) constituting a solar cell, and a power conditioner (30). The PV array (20) is installed on a roof of associate one of the general houses, for example. The PV array (20) generates direct-current power by irradiation of sunlight.

The power conditioner (30) constitutes a solar power conversion unit which converts the direct-current power output by the PV array (20) into alternating-current power. The power conditioner (30) includes a converter section (31), an inverter section (32), and a control unit (40). The control unit (40) and the server (60) together constitute a control system of the power conditioner (30). FIG. 1 illustrates, in detail, the configuration of the power conditioner (30) included in one of the multiple solar power generation units (10), and the configurations of the other power conditioners (30) are not shown.

The converter section (31) constitutes a step-up circuit which increases direct-current voltages output by the PV array (20). A switching device (not shown) is connected to the converter section (31). The inverter section (32) constitutes an inverter circuit which converts the direct-current power output by the converter section (31) into alternating-current power. A plurality of switching devices (not shown) is connected, in a bridge-like manner, to the inverter section (32). In the inverter section (32), on/off timing of each of the switching devices is controlled in accordance with driving signals G sent from the control unit (40). In this manner, in the inverter section (32), the direct-current power having been input is converted into alternating-current power which has a predetermined frequency. The alternating-current power output by the inverter section (32) is supplied to the load (5) which is connected to the commercial power system (3).

The control unit (40) includes a direct-current voltage detecting section (41), a direct current detecting section (42), an arithmetic section (43), a memory section (44), and a voltage controlling section (45).

The direct-current voltage detecting section (41) is configured to detect direct-current voltages Vc which are output from the PV array (20) to the converter section (31). The direct current detecting section (42) is configured to detect direct currents Ic which are output from the PV array (20) to the converter section (31). The direct-current voltage detecting section (41) and the direct current detecting section (42) together constitute a power detecting section which detects output power of the PV array (20).

The detected direct-current voltages Vc and the detected direct currents Ic are input to the control unit (40) with a predetermined period. The arithmetic section (43) calculates the output power of the PV array (20) on the basis of the detected direct-current voltages Vc and the direct currents Ic. The output power P calculated by the arithmetic section (43) is gradually stored in the memory section (44) which includes, e.g., random-access memory (RAM). In addition, the detected direct-current voltages Vc (i.e., detected output voltages V of the PV array (20)) are gradually stored in the memory section (44).

The voltage controlling section (45) is configured to perform the maximum power point tracing (MPPT) control (i.e., the so-called "hill-climbing method"). Specifically, the voltage controlling section (45) adjusts the output voltages of the PV array (20) such that the output power (i.e. the operating point) of the PV array (20) approaches the maximum power point. For example, the voltage controlling section (45) outputs the driving signals G to the converter section (31) to control the on/off timing of the switching device, and thereby adjusts the output voltages of the PV array (20). The voltage controlling section (45) also changes the output voltages of the PV array (20) with a predetermined period T₁ (e.g., a period of 0.5 second). The MPPT control will be detailed later.

The control unit (40) includes a communication section (46) and a power correcting section (47).

The communication section (46) of the control unit (40) is connected to a communication section (61) included in the server (60) through a transmission section (7). The transmission section (7) is configured to transmit signals in both directions between the communication sections (46, 61), and may be wired or wireless. The communication section (46) of the control unit (40) outputs signals indicative of power productions of the solar power generation unit (10). These signals indicative of power productions are input to the communication section (61) of the server (60) through the transmission section (7). The communication section (61) of the server (60) outputs indexes (which will be detailed later) related to amounts of insolation, and the indexes are then input to the communication section (46). Thus, the communication section (46) constitutes an insolation amount inputting section to which the indexes related to amounts of insolation are input. After having been input to communication section (46), the indexes related to amounts of insolation are gradually stored in the memory section (44).

The power correcting section (47) is configured to correct, in the MPPT control, the output power of the PV array (20) on the basis of the indexes related to amounts of insolation which have been input. Specifically, the power correcting section (47) calculates a rate α of change (α = S/S_{old}, where S is an amount of insolation after occurrence of a change, and S_{old} is an amount of insolation before occurrence of the change) with a predetermined period T₂, and then multiplies the output power P by this rate α. The voltage controlling section (45) adjusts the output voltage of the PV array (20) on the basis of corrected output power Pₚᵣₑ.

### <Configuration of Server>

The server (60) includes the communication section (61), a memory section (62), and an arithmetic section (63). The communication section (61) is connected to the communication sections (46) of the multiple solar power generation units (10) through the corresponding transmission sections (7). Thus, the server (60) constitutes a centralized control section which integrates information on the multiple solar power generation units (10). Power productions of the solar power generation units (10) are input to the communication section (61) of the server (60). Thus, the communication section (61) constitutes a power production inputting section to which the power productions of the multiple PV arrays (20) are input. The power productions having been input to the communication section (61) are gradually stored in the memory section (62).

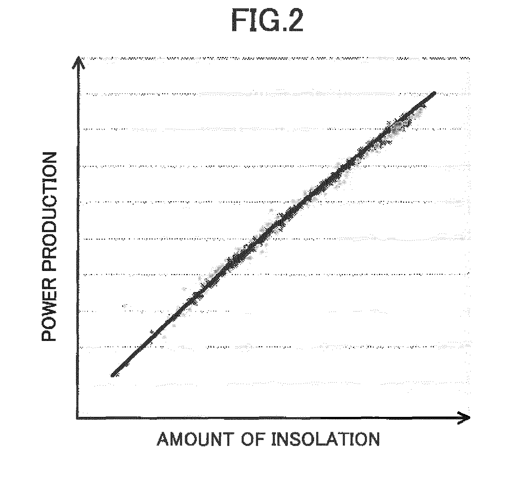

The arithmetic section (63) constitutes an insolation amount estimation section which estimates the amount of insolation on the basis of the power productions stored in the memory section (62). Specifically, the arithmetic section (63) gradually calculates an average value of the power productions at a point of time of all of the solar power generation units (10). Here, the power production of each of the solar power generation units (10) is substantially proportional to the amount of insolation with which the associated PV array (20) is irradiated (see FIG. 2). Accordingly, taking the average value of the power productions of all of the solar power generation units (10) at a predetermined point of time enables estimation of the amount of insolation at the predetermined point of time in the area where all of the solar power generation units (10) are located. The arithmetic section (63) calculates the amount of insolation of the area by means of multiplying the average value of the power productions of the multiple solar power generation units (10) by a predetermined proportionality constant. The amount of insolation calculated by the arithmetic section (63) is input to the communication section (46) of each of the solar power generation units (10) through the associated transmission section (7), and then, is utilized for the correction of the output power that the power correcting section (47) performs.

### <Basic Operation in MPPT Control>

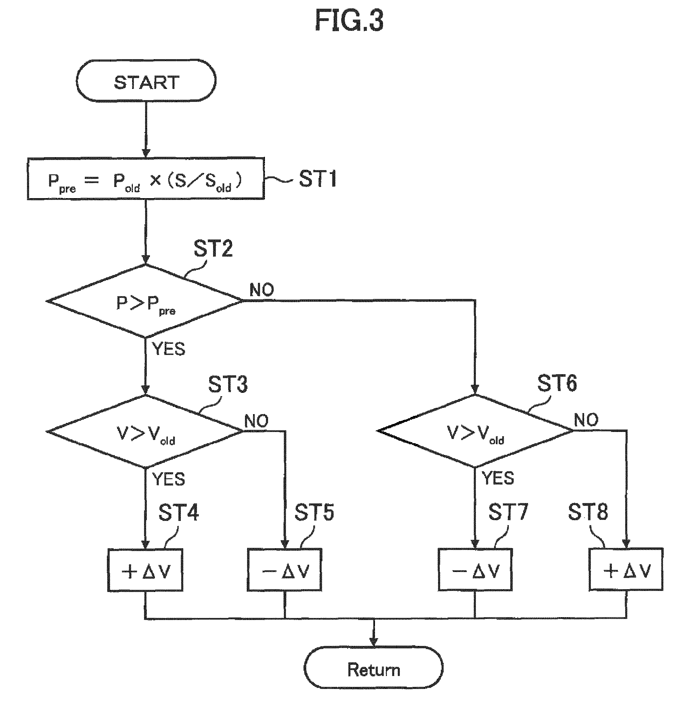

Basic operation in the MPPT control is now described with reference to FIGS. 1 and 3.

In the MPPT control, the detected output power and detected output voltages of the PV array (20) are stored in the memory section (44). Upon staring the MPPT control, the output power of the PV array (20) is corrected in Step ST1. Since the output power P_{old} which was output before occurrence of a fluctuation of the operating point of the PV array (20) is zero immediately after stating of the MPPT control, an estimated output power Pₚᵣₑ(i.e. an estimated output power allowing for a change in amount of insolation) is also zero.

In Step ST2, the latest output power P stored in the memory section (44) is compared to the estimated output power Pₚᵣₑ. Immediately after the starting of the MPPT control, it is determined that the output power P is higher than the estimated output power Pₚᵣₑ, which is equal to zero. Accordingly, the operation proceeds to Step ST3.

In Step ST3, the latest output voltage V stored in the memory section (44) is compared to the output voltage V_{old} which was output before occurrence of the fluctuation of the operating point of the PV array (20). Since the voltage V_{old} is zero immediately after the starting of the MPPT control, the operation proceeds to Step ST4. Consequently, the voltage controlling section (45) slightly changes the output voltage V of the PV array (20) only by an amount of +ΔV. Thus, the output voltage is slightly increased in Step ST4.

The operation then returns to Step ST1, where the output power P_{old} which was output immediately before the change in the output voltage V is corrected. Specifically, in Step ST1, the power correcting section (47) calculates a rate of change of the amount of insolation on the basis of the amounts of insolation stored in the memory section (44). Here, S is the latest mount of insolation stored in the memory section (44), and S_{old} is an amount of insolation before occurrence of the fluctuation of the operating point of the PV array (20) in the previous routine. That is, the formula S/S_{old} represents the rate of change between an amount of insolation before occurrence of a change in the output voltage V and an amount of insolation after occurrence of the change in the output voltage V. In Step ST1, the output power P_{old} is multiplied by S/S_{old} (= α) to obtain the estimated output power Pₚᵣₑ allowing for a change in amount of insolation.

Thereafter, if it is determined that the latest output power P is higher than the estimated output power Pₚᵣₑ in Step ST2 for example, the operation proceeds to Step ST3 again. In the previous routine, the output voltage V was increased in Step ST4. Accordingly, in Step ST3, it is now determined that the latest output voltage V is higher than the previous output voltage V_{old}. The operation accordingly proceeds to Step ST4 again, and the output voltage is increased again. Repetition of the above routines causes a gradual increase in the output voltage V, and thereby causes the output power P to increase and to approach the maximum power point.

On the other hand, when the output voltage V excessively increases in the above manner, it is determined that the latest output power P is lower than the estimated output power Pₚᵣₑ in Step ST2. In this case, the operation proceeds to Step ST6. Since it is determined, in Step ST6, that the latest output voltage V is higher than the previous output voltage V_{old}, the operation proceeds to Step ST7. Consequently, the voltage controlling section (45) slightly changes the output voltage of the PV array (20) only by an amount of -ΔV. Thus, the output voltage is slightly reduced in Step ST7.

Thereafter, if it is determined that the latest output power P is higher than the previous estimated output power Pₚᵣₑ in Step ST2, the operation proceeds to Step ST3. In this case, it is determined that the latest output voltage V is lower than the previous output voltage V_{old}, the operation accordingly proceeds to Step ST5, where the output voltage of the PV array (20) is further reduced slightly.

On the other hand, when it is determined, in Step ST2, that the latest output power P is lower than the previous estimated output power Pₚᵣₑ, the operation proceeds to Step ST6. In this case, it is determined that the latest output voltage V is lower than the previous output voltage V_{old}, the operation accordingly proceeds to Step ST8, where the output voltage of the PV array (20) is increased.

The above routines are repeated in the MPPT control in the manner as described above, and consequently, the output power of the PV array (20) is caused to change in a stepwise manner and to approach the maximum power point.

### <Output Power Correction Based on Amount of Insolation>

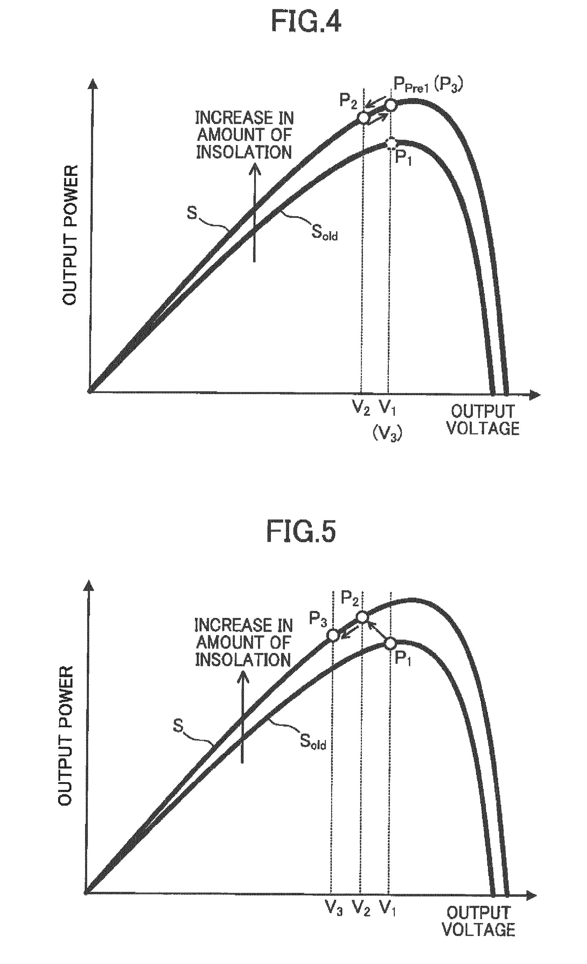

As described above, in the MPPT control of this embodiment, the previous output power P_{old} is corrected based on a rate of change of the amount of insolation in Step ST1. This enables reduction in losses of the output power (the so-called MPPT losses) of the PV array (20) which are caused when the amount of insolation with which the PV array (20) is irradiated abruptly changes. The reduction in the MPPT losses is now described with reference to FIGS. 3-5. FIG. 4 is a graph of I-V characteristic, and shows an example of fluctuation of the operating point of the PV array (20) in the MPPT control of this embodiment. FIG. 5 is a graph of I-V characteristic, and shows an example of fluctuation of the operating point of a PV array in conventional MPPT control.

Referring to the conventional MPPT control shown in FIG. 5, let us suppose, for example, that the output voltage V is reduced from V₁ to V₂, and at the same time as this reduction, the amount of insolation abruptly increases from the amount S_{old} before occurrence of fluctuation of the operating point to the amount S. This kind of change in amount of insolation may occur when a PV array which has been in the shade becomes directly irradiated with sunlight, for example. This abrupt increase in amount of insolation causes the output power to increase to P₂. In this case, in the conventional MPPT control, since it is determined that the reduction in the output voltage from V₁ to V₂ has caused the increase in the output power from P₁ to P₂, control by which the output voltage is further reduced from V₂ to V₃ is performed. Consequently, according to the I-V characteristic corresponding to the amount S of insolation, the output power of the PV array decreases from P₂ to P₃ and thereby moves away from the maximum power point.

On the other hand, the MPPT control of this embodiment reduces, by means of correcting the output power on the basis of amounts of insolation, transition of the operating point in a wrong direction which may be caused by an abrupt change in amount of insolation as described above. Specifically, referring to the MPPT control of this embodiment shown in FIG. 4, let us suppose, for example, that the output voltage V is reduced from V₁ to V₂, and at the same time as this reduction, the amount of insolation abruptly increases from the amount S_{old} to the amount S, in a manner similar to the example shown in FIG. 5. According to this embodiment, in Step ST1, the previous output power P_{old} (i.e., P₁ in FIG. 4) is multiplied by the rate of change of amount of insolation (i.e., S/S_{old}), resulting in that output power (i.e., the estimated output power Pₚᵣₑ₁ in FIG. 4) allowing for the rate of change of amount of insolation is calculated. Accordingly, since it is determined, in Step ST2, that the latest output power P (i.e., P₂ in FIG. 4) is lower than the estimated output power Pₚᵣₑ₁, the operation proceeds to Step ST6 and then to Step ST8, resulting in that control by which the output voltage is increased is performed. In other words, in this example, the output voltage increases from V₂ to V₃, and this increase in the output voltage causes the output power to increase from P₂ to P₃. Consequently, according to the I-V characteristic corresponding to the amount S of insolation, the output power of the PV array (20) is caused to approach the maximum power point.

### - Advantages of Embodiment -

In the above embodiment, the output power P_{old} of the PV array (20) is corrected based on the amounts of insolation. In this manner, it is possible to prevent the output power from moving away from the maximum power point due to an abrupt change in amount of insolation as shown in FIG. 5. As a result, the so-called MPPT losses can be reduced, and power generation efficiency of the solar power generation units (10) can be improved.

In the above embodiment, the amount of insolation is estimated based on the average value of power productions of the PV arrays (20) of the multiple solar power generation units (10). It is therefore unnecessary to provide an insolation amount measurement section for each of the multiple solar power generation units (10). The costs for the solar power generation system (1) can be reduced accordingly.

In the above embodiment, reception of the information on the power productions of the solar power generation units (10) and transmission of the estimated amount of insolation to the solar power generation units (10) are performed through the sever (60) located on the network. Therefore, information can be easily supplied to all of the solar power generation units (10) located in a predetermined region.

### 〈〈Other Embodiment〉〉

In the above embodiment, the amount of insolation is estimated based on the power productions of the multiple solar power generation units (10). However, an insolation amount measurement section or an illuminometer may be employed to provide indexes related to amounts of insolation. It is also possible to calculate an average amount of insolation in a predetermined region on the basis of detected values which have been sent to a server through a network from a plurality of illuminometers installed in the predetermined region.

Further, the amount of insolation may be estimated based on the sum of the power productions (the total power production), instead of the average value of the power productions of the multiple solar power generation units (10).

Furthermore, although the control system and control method of the present disclosure are applied to the solar power generation system including the multiple solar power generation units (10) in the above embodiment, it is also possible to apply the control system and control method of the present disclosure to one solar power generation unit (10) in the following manner. Specifically, an insolation amount detecting section (i.e., an insolation amount measure or an illuminometer) may be provided near a solar cell (20) of the solar power generation unit (10). The output power of the solar cell (20) may be corrected based on indexes related to amounts of insolation which are provided by the insolation amount detecting section. The output voltage of the solar cell (20) may be changed based on the corrected output power such that the output power will approach the maximum power point.

Note that the foregoing embodiments have been set forth merely for purposes of substantially preferred examples, and are not intended to limit the scope, applications, and use of the present disclosure.

### INDUSTRIAL APPLICABILITY

As described above, present disclosure is useful for a control system for a solar power conversion unit, a control method for the unit, and a solar power generation system.

### DESCRIPTION OF REFERENCE CHARACTERS

- 20: Solar cell
- 30: Solar power conversion unit (Power conditioner)
- 40: Control unit (Control system)
- 41: Direct-current voltage detecting section (Power detecting section)
- 42: Direct current detecting section (Power detecting section)
- 45: Voltage controlling section
- 46: Insolation amount inputting section (Communication section)
- 47: Power correcting section
- 60: Server (Control system)
- 61: Power production inputting section (Communication section)
- 63: Insolation amount estimation section (Arithmetic section)

## Claims

1. A control system for a solar power conversion unit configured to convert direct-current power output by at least one solar cell (20) into alternating-current power, the control system comprising:
a power detecting section (41, 42) configured to detect the power output by the solar cell (20);
an insolation amount inputting section (46) to which an index related to an amount of insolation is input;
a power correcting section (47) configured to correct the output power detected by the power detecting section (41, 42) on the basis of the index related to the amount of insolation input to the insolation amount inputting section (46); and
a voltage controlling section (45) configured to change an output voltage of the solar cell (20) on the basis of the output power corrected by the power correcting section (47) such that the output power of the solar cell (20) approaches a maximum power point.

2. The control system of claim 1, wherein
the at least one solar cell (20) comprises multiple solar cells (20),
the system further includes:
a power production inputting section (61) to which power productions of the multiple solar cells (20) are input; and
an insolation amount estimation section (63) configured to estimate the amount of insolation on the basis of the multiple power productions input to the power production inputting section (61), and
the amount of insolation estimated by the insolation amount estimation section (63) is input to the insolation amount inputting section (46).

3. The control system of claim 2, wherein
the power correcting section (47) corrects the output power detected by the power detecting section (41, 42) by means of multiplying the output power detected by the power detecting section (41, 42) by a rate of change of the amount of insolation.

4. A control method for a solar power conversion unit configured to convert direct-current power output by at least one solar cell (20) into alternating-current power, the control method comprising:
correcting detected output power of the solar cell (20) on the basis of an index related to an amount of insolation; and
changing an output voltage of the solar cell (20) on the basis of the corrected output power such that the output power of the solar cell (20) approaches a maximum power point.

5. The control method of claim 4, wherein
the at least one solar cell (20) comprises multiple solar cells (20),
the amount of insolation is estimated based on power productions of the multiple solar cells (20), and
detected output power of the solar cells (20) is corrected based on the estimated amount of insolation.

6. The control method of claim 5, wherein
the detected output power of the solar cells (20) is corrected by means of multiplying the detected output power of the solar cells (20) by a rate of change of the amount of insolation.

7. A solar power generation system comprising:
multiple solar cells (20);
multiple solar power conversion units (30) each configured to convert direct-current power output by an associated one of the solar cells (20) into alternating-current power; and
the control system (40, 60) of claim 2 or 3.
